# EUROPÄISCHE PATENTSCHRIFT

(11) **EP 4 123 315 B1**
(45) Veröffentlichungstag und Bekanntmachung des Hinweises auf die Patenterteilung: **06.11.2024**
(21) Anmeldenummer: 22020350.9
(22) Anmeldetag: 21.07.2022
(51) Int. Cl.: G01R 1/04, G01R 1/067, G01R 31/55, H02S 50/10

(54) **SICHERHEITS-KONTAKTIERVORRICHTUNG ZUM ERKENNEN VON KABELN VON SOLARZELLEN UND ZUM MESSEN VON GLEICH- UND WECHSELSPANNUNGEN UND STRÖMEN AN WEITEREN SPANNUNGSFÜHRENDEN KABELN**
SAFETY CONTACT DEVICE FOR DETECTING CABLES OF SOLAR CELLS AND FOR MEASURING DC AND AC VOLTAGES AND CURRENTS AT FURTHER VOLTAGE-CARRYING CABLES
DISPOSITIF DE CONTACT DE SÉCURITÉ PERMETTANT DE DÉTECTER LES CÂBLES DES CELLULES SOLAIRES ET DE MESURER LES TENSIONS CONTINUE ET ALTERNATIVE ET LES COURANTS AU NIVEAU D'AUTRES CÂBLES SOUS TENSION

(30) Priorität: 23.07.2021 DE 102021119095
(43) Veröffentlichungstag der Anmeldung: 25.01.2023
(73) Patentinhaber: Innoperform GmbH, 02694 Malschwitz-Preititz (DE)
(72) Erfinder: Bank, Steffen, 67722 Winnweiler (DE); Höring, Heiko, 67722 Winnweiler (DE)
(74) Vertreter: Kinnstätter, Klaus

(56) Entgegenhaltungen:
- DD-A1- 120 978
- US-A- 2 515 004
- US-A- 3 864 629
- US-A- 4 658 212
- US-A- 5 084 673
- US-A- 5 834 929

## Beschreibung

Die Erfindung betrifft eine Sicherheits-Kontaktiervorrichtung zum Erkennen von zwei zueinander gehörenden Kabeln einer Solarzellenreihenschaltung.

Aus der WO 2009/132 468 A2 sind Solarzellen bekannt. Solarzellen, die häufig auch als Solarpaneele bezeichnet werden, sind an Häuserwänden und auf Dächern von Häusern angeordnet. Solarzellen wandeln Sonnenenergie in elektrische Energie um. Sie werden üblicherweise in Reihe geschaltet, um die von ihnen erzeugten Gleichspannungen zu addieren.

Zum Abgreifen und Nutzen der Gleichspannung führt von einer ersten Solarzelle ein Anfangskabel vom Dach oder einer Häuserwand bevorzugt nach unten, und führt von einer letzten Solarzelle der in Reihe geschalteten Solarzellen ein Endkabel nach unten. Üblicherweise werden die beiden Kabel in einen Keller oder Versorgungsraum eines Gebäudes geführt, um dort verdrahtet zu werden.

Da auf einem Dach oder an einer Häuserwand aber nicht nur eine Reihe von Solarzellen, sondern eine Vielzahl von Reihen angeordnet sein können, führen nicht nur zwei Kabel, also ein zugehöriges Paar, in den Keller, sondern eine Vielzahl von Paaren, an denen eine Gleichspannung abgegriffen werden kann.

Der Monteur sieht sich in einem Keller oder Versorgungsraum der Aufgabe gegenüber, aus einem wirren Bündel von sehr vielen Kabeln stets die zwei zusammengehörigen Kabel herauszufinden, die ein Paar bilden, nämlich das jeweilige Anfangskabel einer in Reihe geschalteten ersten Solarzelle und das zugehörige Endkabel der letzten Solarzelle der Reihe.

Da die Solarzellen Gleichspannung erzeugen, ist eine kontaktfreie elektrische Vermessung der Kabel nicht möglich. Jedes Kabel muss vom Monteur in die Hand genommen werden, und mit einer Messelektrode, beispielsweise einer Leitung, die zu einem Multimeter führt, muss der metallische Kabelkern jedes Kabels physisch kontaktiert werden.

Damit die Gleichspannung detektiert werden kann, muss der Monteur also zunächst ein erstes Kabel in die Hand nehmen und mit einer ersten Messelektrode in Kontakt bringen. Diese erste Messelektrode und das erste Kabel müssen vom Monteur mit einer Hand in Kontakt verbleibend gehalten werden, wobei der Monteur dann mit der anderen Hand aus dem Bündel an Kabeln das zum ersten Kabel zugehörige Kabel ermitteln muss, indem er eine zweite Messelektrode an den metallischen Kern eines zweiten Kabels führt. Der Monteur muss also alle noch verbleibenden Kabel durchtesten, bis er das richtige gefunden hat. Hierbei besteht die Gefahr, dass der Monteur von einem metallischen Kern abrutscht und mit seinem Finger an den metallischen Kern gelangt. Wenn der menschliche Körper in direkten Kontakt mit den metallischen Kabelkernen eines solchen Paars kommt, liegt an ihm eine Gleichspannung von bis zu 3000 Volt an, was zu erheblichen gesundheitlichen Schäden führen kann.

Aus der DD 120 978 A1 ist eine selbsthaltende Klemmvorrichtung bekannt, mittels derer eine schnelle und sichere elektrische Kontaktierung eines elektrischen Leiters erreicht werden kann, insbesondere zur Durchführung von elektrischen Mess- und Prüfvorgängen. Die Klemmvorrichtung besteht aus einem elektrisch nichtleitenden zylindrischen Teil, an dessen Ende eine rechteckige Nut eingearbeitet ist. In der rechteckigen Nut ist quer zur axialen Richtung eine exzentrische drehbar gelagerte nichtverzahnte Spannwalze aus nichtleitendem Material mit hohem Reibwert angeordnet. Im Innern des zylindrischen Teils ist in axialer Richtung eine zylindrische Bohrung angeordnet, die in der rechteckigen Nut mündet bzw. ausläuft. Ein zu prüfender Leiter wird mit seinem Leiterende in die Nut zwischen Nutgrund und Spannwalze so weit geführt, dass seine Querschnittsfläche auf eine Kontaktfläche eines Kontaktkolbens auftrifft und der Kontaktkolben in axialer Richtung gegen die Kraft der Schraubenfeder verschoben wird, so dass über der Kontaktkolbenfläche und die Querschnittsfläche des Leiters ein elektrischer Kontakt hergestellt ist. Durch Drehen der Spannwalze wird der Leiter zwischen Nutgrund und Spannwalze geklemmt. Dabei wird durch die Kraft der Schraubenfeder auf den Leiter die Spannwalze selbsttätig in dieser Stellung gehalten. Die Klemmvorrichtung der DD 120 978 A1 kann insbesondere zum Prüfen einer Vielzahl von isolierten Einzelleitern verwendet werden, um eine Spannungsprüfung jedes Einzelleiters gegen alle übrigen Einzelleiter durchzuführen.

Der Erfindung liegt die Aufgabe zu Grunde, eine Sicherheits-Kontaktiervorrichtung zu schaffen, bei denen die Kabel in der Sicherheits-Kontaktiervorrichtung zuverlässiger als im Stand der Technik kontaktierbar sind.

Die vorliegende Erfindung löst die zuvor genannte Aufgabe durch die Merkmale des Anspruchs 1.

Erfindungsgemäß ist erkannt worden, dass eine Sicherheits-Kontaktiervorrichtung zum Erkennen von zwei zueinander gehörenden Kabeln einer Solarzellenreihenschaltung verhindern kann, dass der Monteur in unmittelbaren körperlichen Kontakt mit dem metallischen Kern eines Kabels kommen kann. Weiter ist erkannt worden, dass mindestens eine erste Messelektrode mit einer Spitze zum Anlegen an den Kern eines ersten Kabels gerichtet geführt werden muss, um den metallischen Kern des Kabels sicher zu treffen und zwar ohne, dass der Monteur die Messelektrode selbst bewegt. Weiter ist erkannt worden, dass ein Grundkörper mit einer Kabelaufnahme zum Einführen und Halten mindestens eines der Kabel das Kabel beim Einführen der Messelektrode direkt zuführen kann. Weiter ist erkannt worden, dass die Messelektrode innerhalb des Grundkörpers durch Führungsmittel geführt werden muss, damit der metallische Kern, ohne das Kabel abzuisolieren, zielsicher getroffen und physisch kontaktiert werden kann. Auch ist erkannt worden, dass eine Kabelaufnahme das Kabel zumindest zu einem gewissen Maß fixiert und mit der Messelektrode in Kontakt hält, ohne dass der Monteur aktiv die Messelektrode gegen den metallischen Kern gedrückt halten muss. Schließlich ist erkannt worden, dass die Kabelaufnahme koaxial zur Bewegungsachse durch die Messelektrode angeordnet sein sollte, so dass die Spitze der Messelektrode stets den metallischen Kern des ersten Kabels trifft. Durch diese Sicherheits-Kontaktiervorrichtung hat der Monteur nun beide Hände frei, um mit einer zweiten Messelektrode den metallischen Kern eines zweiten Kabels zu ertasten und dadurch das Kabel herauszufinden, welches mit dem Kabel in der Sicherheits-Kontaktiervorrichtung ein Paar ausbildet, nämlich ein Paar aus Anfangs- und Endkabel bildet.

Die Sicherheits-Kontaktiervorrichtung stellt außerdem sicher, dass der Monteur nicht mehr durch Gleichspannung geschädigt werden kann, weil das einzige Kabel, welches gemeinsam mit dem von ihm händisch gehaltenen Kabel eine Spannung an seinen menschlichen Körper anlegen könnte, bereits in der Sicherheits-Kontaktiervorrichtung gehalten ist. Die Kabelaufnahme schirmt das in ihr gehaltene Kabel, nämlich insbesondere den metallischen Kern, gegen ungewollten Zugriff ab.

Erfindungsgemäß umfassen die Führungsmittel eine Feder, durch welche die Messelektrode federnd gelagert ist, wobei die Feder gegen eine Rückstellkraft bewegbar ist. So kann ein Kabel soweit in die Kabelaufnahme eingeschoben werden, bis die Messelektrode unter Pressung am metallischen Kern anliegt. Die Messelektrode bietet dem Kabel beim Einschieben einen federnd beweglichen Widerstand.

Erfindungsgemäß sind der Kabelaufnahme Arretiermittel zugeordnet, um das Kabel gegen ein Herausrutschen aus der Kabelaufnahme zu sichern. Die Arretiermittel drücken gegen den Mantel des Kabelse und fixieren dieses dadurch kraftschlüssig.

Die Arretiermittel könnten durch eine Betätigungseinrichtung händisch bedienbar sein, um das Kabel freizugeben oder zu fixieren. So kann der Monteur aktiv bestimmen, ob ein Kabel in der Kabelaufnahme verbleiben soll oder aus dieser herausgezogen werden soll.

Die Betätigungseinrichtung könnte einen Hebel aufweisen, der um eine Schwenkachse schwenkbar ist. Ein Hebel ist leicht mit einem Finger, insbesondere dem Daumen, betätigbar. Der Hebel könnte federbelastet sein, so dass ein Arretiermittel automatisch nach radial innen drückt, wenn der Hebel nicht gedrückt bzw. entlastet ist.

Der Grundkörper könnte mindestens eine Leitung mit einem Stecker aufweisen, wobei die Leitung elektrisch leitend mit der Messelektrode verbunden ist. So kann die Sicherheits-Kontaktiervorrichtung leicht an ein übliches Messgerät zum Messen von elektrischen Strömen und Spannungen, beispielsweise ein Multimeter, angeschlossen werden.

Der Grundkörper könnte zwei Kabelaufnahmen mit jeweils einer der jeweiligen Kabelaufnahme zugeordneten Messelektrode aufweisen. So können immer zwei Kabel in die Sicherheits-Kontaktiervorrichtung eingesteckt werden und der Monteur kann dann das Messgerät leichter bedienen.

Eine Kabelaufnahme könnte mehrere hintereinander angeordnete Arretierbereiche mit jeweils zu einem anderen Arretierbereich unterschiedlichem Innendurchmesser aufweisen. So können Kabel unterschiedlicher Dicke in die hier beschriebene Sicherheits-Kontaktiervorrichtung eingesetzt werden.

Die Sicherheits-Kontaktiervorrichtung könnte mittels einer Leitung mit einem Messgerät zur Messung von elektrischen Strömen oder Spannungen verbunden sein oder der Grundkörper könnte einstückig mit einem solchen Messgerät ausgebildet sein. Durch die einstückige Ausgestaltung der Sicherheits-Kontaktiervorrichtung oder mehrerer Sicherheits-Kontaktiervorrichtungen mit einem Messgerät, insbesondere einem Multimeter, können besonders leicht Kabel für Solarzellen geprüft und untersucht werden.

Die hier beschriebene Sicherheits-Kontaktiervorrichtung wird bevorzugt zur Prüfung von Kabeln von Solarzellen verwendet.

Die DIN-Normen für Kabel, die als Solarkabel verwendet werden, lauten wie folgt: DIN EN 60228 Klasse 5 (Leiteraufbau), EN 60811, EN 50267-2-1, EN 50363. Die DIN-Normen für Messgeräte und Prüfadapter lauten wie folgt: IEC 61010 1 (international), DIN EN 61010 1 (deutsche Fassung) bzw. VDE Klassifikation VDE 0411-1, Produktnormen für Geräte zum Prüfen, Messen oder Überwachen von Schutzmaßnahmen: IEC 61557 Teil 1 bis 16 (international), DIN EN 61557 Teil 1 bis 16 (deutsche Fassung) bzw. DIN VDE 0413 Teil 1 bis 16. Die derzeit gültigen Produktnormen lauten EC 61010-1:2010 + Cor.:2011, DIN EN 61010-1:2011-07 und VDE 0411-1:2011-07.

Die hier beschriebene Sicherheits-Kontaktiervorrichtung wird zum Erkennen von Kabeln von Solarzellen und zum Durchführen von Messungen zur Ermittlung von Gleich- und Wechselspannungen und Strömen an weiteren spannungsführenden Kabeln verwendet.

In der Zeichnung zeigen
- Fig. 1: eine schematische Ansicht von mehreren Reihen hintereinander geschalteter Solarzellen, deren jeweilige Anfangs- und Endkabel innerhalb eines wirren Kabelbündels in einen Versorgungsraum eines Gebäudes zur weiteren Verdrahtung durch einen Monteur geführt sind,
- Fig. 2: eine schematische Ansicht des Details A aus Fig. 1, nämlich ein Kabelende, dessen metallischer Kern durch eine Messelektrode physisch kontaktiert ist, wobei die Messelektrode mittels einer Leitung mit einem Multimeter verbunden ist, von welchem eine weitere Leitung mit einer weiteren Messelektrode abgeht,
- Fig. 3: eine schematische Schnittansicht einer Sicherheits-Kontaktiervorrichtung mit einer federnd gelagerten Messelektrode, welche mit einem metallischen Kern eines Kabels in elektrischem und physischem Kontakt steht, wobei das Kabel in einer Kabelaufnahme durch Arretiermittel gegen ein Herausrutschen fixiert ist,
- Fig. 4: eine schematische Schnittansicht einer Sicherheits-Kontaktiervorrichtung, in welcher zwei Kabel in je einer Kabelaufnahme durch Arretiermittel gegen ein Herausrutschen fixiert sind, und
- Fig. 5: eine Kabelaufnahme für eine Sicherheits-Kontaktiervorrichtung nach Fig. 3 oder 4, welche mehrere koaxial angeordnete Arretierbereiche mit unterschiedlichen Innendurchmessern aufweist.

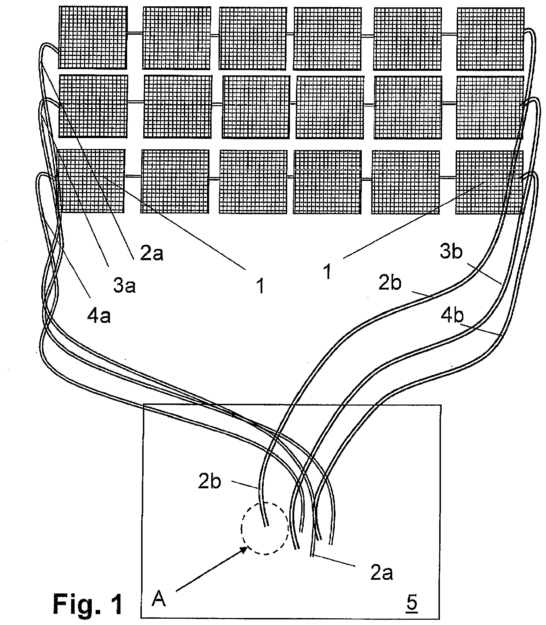

Fig. 1 zeigt eine schematische Ansicht von mehreren Reihen hintereinander geschalteter Solarzellen 1, deren jeweilige Anfangs- und Endkabel 2a, 3a, 4a, 2b, 3b, 4b innerhalb eines wirren Kabelbündels mit ungeordnet vorliegenden Kabelenden in einen Versorgungsraum 5 eines Gebäudes zur weiteren Verdrahtung durch einen Monteur geführt sind.

Eine Reihe aus mehreren Solarzellen 1 kann 750 bis 3000 Volt zwischen einem Anfangskabel 2a, 3a, 4a und einem Endkabel 2b, 3b, 4b aufbauen. Ein solches Kabel 2a, 3a, 4a, 2b, 3b, 4b kann einen metallischen Kern von 4 mm², 6 mm², 10 mm² oder 16 mm² aufweisen. Fig. 1 zeigt durch das gestrichelt dargestellte Detail A das nicht abisolierte Ende eines Endkabels 2b, welches mit dem Anfangskabel 2a ein Paar bildet, an dem eine Gleichspannung abgegriffen werden kann.

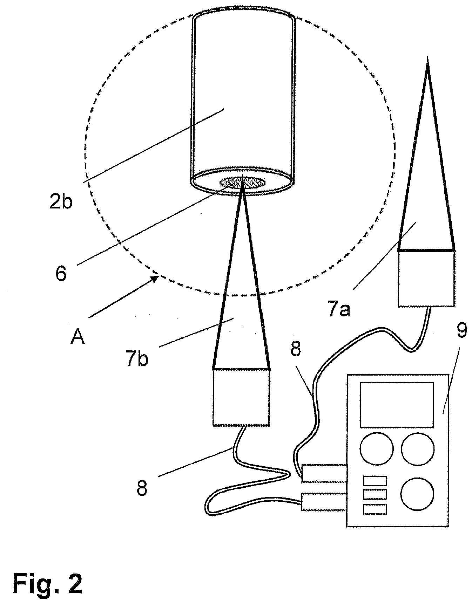

Fig. 2 zeigt eine schematische Ansicht des Details A aus Fig. 1, nämlich ein Kabelende, dessen metallischer Kern 6 durch eine Messelektrode 7b (genauer: deren Spitze) physisch kontaktiert ist, wobei die Messelektrode 7b mittels einer Leitung 8 mit einem Multimeter 9 verbunden ist, von welchem eine weitere Leitung 8 mit einer weiteren noch freien Messelektrode 7a abgeht.

Bei einer Methode nach dem Stand der Technik muss der Monteur nun aus dem Kabelbündel aus Fig. 1 das Anfangskabel 2a herausfinden, indem er die noch freie Messelektrode 7a mit den übrigen Kabeln 2a, 3a, 4a, 3b, 4b in Kontakt bringt, solange bis das Multimeter 9 eine Gleichspannung anzeigt. Hierbei muss der Monteur darauf achten, dass er körperlich nicht mit beiden metallischen Kernen 6 des Anfangskabels 2a und des Endkabels 2b zugleich in Kontakt kommt.

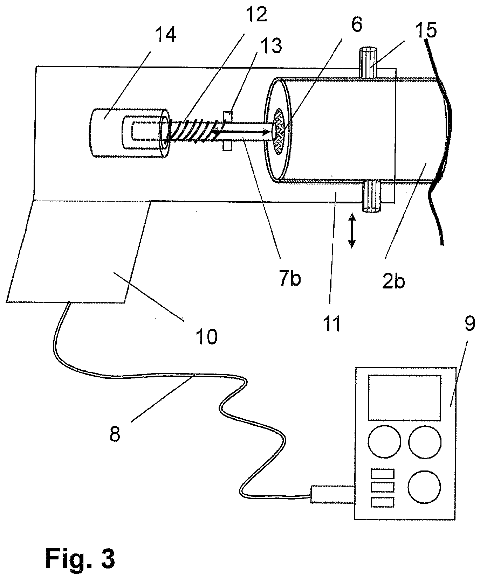

Fig. 3 zeigt eine schematische Schnittansicht einer Sicherheits-Kontaktiervorrichtung mit einer federnd gelagerten Messelektrode 7b, welche mit einem metallischen Kern 6 eines Kabels, hier des Endkabels 2b, in elektrischem und physischem Kontakt steht.

Diese Sicherheits-Kontaktiervorrichtung wird zum Erkennen von zwei zueinander gehörenden Kabeln, nämlich einem Anfangskabel 2a und einem Endkabel 2b, einer Solarzellenreihenschaltung verwendet. Die Sicherheits-Kontaktiervorrichtung umfasst mindestens eine Messelektrode 7b zum Anlegen an den Kern 6 eines Kabels, nämlich des Endkabels 2b, und ist durch einen Grundkörper 10 mit einer Kabelaufnahme 11 zum Einführen und Halten des Endkabels 2b gekennzeichnet, wobei die Messelektrode 7b innerhalb des Grundkörpers 10 durch Führungsmittel geführt ist.

Die Führungsmittel umfassen eine Feder 12, beispielsweise eine Spiralfeder, durch welche die Messelektrode 7b federnd gelagert ist, wobei die Messelektrode 7b gegen eine Rückstellkraft bewegbar ist. Die Messelektrode 7b ist als länglicher Kontaktstift ausgebildet, an dessen Kranz 13 sich die Feder 12 mit einem in Fig. 3 rechten Ende abstützt. Die Feder 12 stützt sich mit ihrem linken Ende an einer Führungshülse 14 ab, in welche der Kontaktstift eintauchen kann und welche einen elektrischen Kontakt zwischen dem Kontaktstift und einer Leitung 8 herstellt.

Die Kabelaufnahme 11 ist koaxial zur Bewegungsachse durch die Messelektrode 7b angeordnet. Die Bewegungsachse durch die Messelektrode 7b fällt mit dem waagerechten Doppelpfeil in Fig. 3 zusammen. Der Doppelpfeil drückt aus, dass die Messelektrode 7b einfedern und ausfedern kann, je nachdem ob das Endkabel 2b in die einseitig offene Kabelaufnahme 11 eingeführt oder herausgeführt wird. Die Kabelaufnahme 11 ist bevorzugt aus einem Kunststoff oder einem anderen elektrisch isolierenden Material gefertigt.

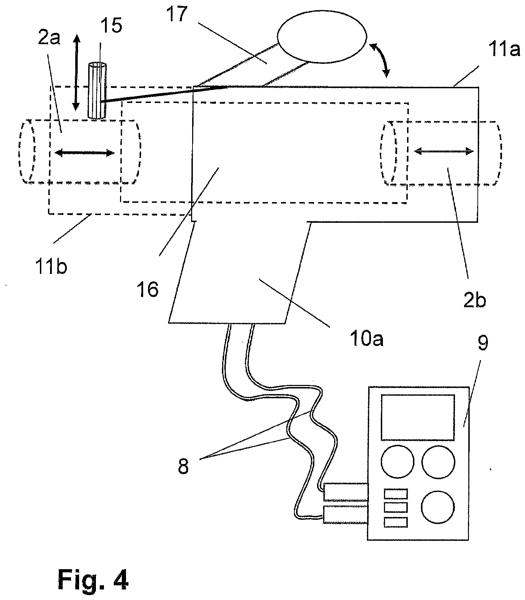

Der Kabelaufnahme 11 sind Arretiermittel 15 zugeordnet, um das Kabel gegen ein Herausrutschen aus der Kabelaufnahme 11 zu sichern. Die Arretiermittel 15 sind radial nach innen beweglich, um gegen den Mantel des Kabels zu drücken. So wird das Kabel kraftschlüssig in der Kabelaufnahme 11 festgelegt, wenn deren Kern 6 die Messelektrode 7b kontaktiert. Die radiale Beweglichkeit der Arretiermittel 15 ist durch den vertikalen Doppelpfeil in Fig. 3 und Fig. 4 dargestellt.

Um das Anfangskabel 2a zu finden, kann nun eine freie Messelektrode 7a wie in Fig. 2 beschrieben verwendet werden. Der Monteur hat nun beide Hände frei, weil das Endkabel 2b in der Sicherheits-Kontaktiervorrichtung gemäß Fig. 3 sicher fixiert ist.

Fig. 4 zeigt anhand einer weiteren Ausgestaltung der Sicherheits-Kontaktiervorrichtung, dass ein Grundkörper 10a zwei Kabelaufnahmen 11a, 11b aufweist, von denen eine das Anfangskabel 2a und die andere das Endkabel 2b fixiert aufnimmt. Es ist im Inneren des Grundkörpers 10a eine Einrichtung 16 vorgesehen, welche zwei federnd gelagerte Messelektroden 7a, 7b in Analogie zu Fig. 3 aufweist. So können stets zwei Kabel untersucht werden, und der Monteur hat beide Hände zur Bedienung des Multimeters 9 frei.

Fig. 4 zeigt auch, dass die Arretiermittel 15 durch eine Betätigungseinrichtung händisch bedienbar sind, um ein Kabel freizugeben oder zu fixieren. Konkret weist die Betätigungseinrichtung einen Hebel 17 auf, der um eine Schwenkachse schwenkbar ist. Dies ist durch den gekrümmten Doppelpfeil dargestellt. Selbstverständlich können durch einen Hebel 17 auch beide Kabel zugleich freigegeben oder fixiert werden. Denkbar ist aber auch, dass zwei Hebel 17 vorgesehen sind, so dass jedes Kabel für sich allein lösbar oder fixierbar ist.

Fig. 3 und 4 zeigen, dass der Grundkörper 10, 10a mindestens eine Leitung 8 mit einem Stecker aufweist, wobei die Leitung 8 elektrisch leitend mit der Messelektrode 7b bzw. 7a verbunden ist. Wenn zwei Messelektroden 7a, 7b vorgesehen sind, sind zwei Leitungen 8 vorgesehen, die zum Multimeter 9 führen.

Fig. 4 zeigt vor diesem Hintergrund, dass der Grundkörper 10a zwei Kabelaufnahmen 11a, 11b mit jeweils einer der jeweiligen Kabelaufnahme 11a, 11b zugeordneten Messelektrode 7a, 7b aufweist.

Vor diesem Hintergrund ist denkbar, dass die hier beschriebene Kontaktvorrichtung nach Fig. 3 oder Fig. 4 bzw. deren Grundkörper 10, 10a einstückig mit einem Messgerät ausgebildet ist. Das Messgerät ist bevorzugt ein entsprechend modifiziertes Multimeter 9.

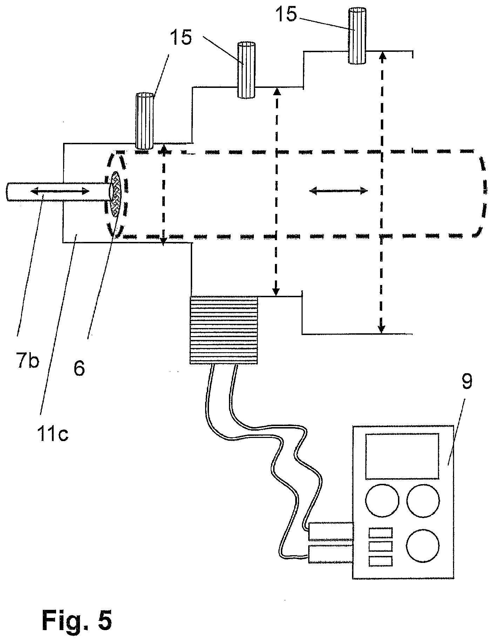

Damit Kabel unterschiedlichen Durchmessers mit der hier beschriebenen Sicherheits-Kontaktiervorrichtung untersucht werden können, weist eine Kabelaufnahme 11c mehrere hintereinander angeordnete Arretierbereiche mit jeweils zu einem anderen, benachbarten Arretierbereich mit einem unterschiedlichen Innendurchmesser auf. Fig. 5 zeigt eine solche Kabelaufnahme 11c. Die unterschiedlichen Innendurchmesser der Arretierbereiche mit Arretiermitteln 15 sind durch gestrichelte Doppelpfeile dargestellt. Die Kabelaufnahme 11c kann mit einer Sicherheits-Kontaktiervorrichtung gemäß Fig. 3 oder 4, aber auch mit einem modifizierten Multimeter 9 kombiniert werden, wenn dieses Multimeter 9 die Sicherheits-Kontaktiervorrichtung ausbildet. Der Arretierbereich mit dem größten Innendurchmesser ist der Messelektrode 7b abgewandt, der Arretierbereich mit dem kleinsten Innendurchmesser ist der Messelektrode 7b zugewandt. Zwischen den Arretierbereichen können Einführschrägen ausgebildet sein, damit ein Kabel besser eingeführt, also quasi eingefädelt, werden kann.

Der Monteur kann daher eine Sicherheits-Kontaktiervorrichtung der hier beschriebenen Art mit sich führen.

### Bezugszeichenliste:

- 1: Solarzelle
- 2a, 3a, 4a: Anfangskabel von 1
- 2b, 3b, 4b: Endkabel von 1
- 5: Versorgungsraum
- 6: Kern von 2a, 3a, 4a, 2b, 3b, 4b
- 7a, 7b: Messelektrode
- 8: Leitung zu 9
- 9: Multimeter
- 10, 10a: Grundkörper
- 11, 11a-c: Kabelaufnahme
- 12: Feder
- 13: Kranz von 7b
- 14: Führungshülse
- 15: Arretiermittel von 11, 11a-c, 18
- 16: Einrichtung
- 17: Hebel

## Patentansprüche

1. Sicherheits-Kontaktiervorrichtung zum Erkennen von zwei zueinander gehörenden Kabeln einer Solarzellenreihenschaltung, umfassend mindestens eine erste Messelektrode (7a, 7b) mit einer Spitze zum Anlegen an den Kern (6) eines ersten Kabels, mit einem Grundkörper (10, 10a) mit einer Kabelaufnahme (11, 11a, 11b, 11c) zum Einführen und Halten mindestens eines der Kabel, wobei die Messelektrode (7a, 7b) innerhalb des Grundkörpers (10, 10a) durch Führungsmittel geführt und in Richtung der Kabelaufnahme (11, 11a, 11b, 11c) und/ oder des Kabels verbringbar ist, wobei die Kabelaufnahme (11, 11a, 11b, 11c) koaxial zur Bewegungsachse durch die Messelektrode (7a, 7b) angeordnet ist, so dass die Spitze der Messelektrode stets den metallischen Kern (6) des ersten Kabels trifft, wobei die Führungsmittel eine Feder (12) umfassen, durch welche die Messelektrode (7a, 7b) federnd gelagert ist, wobei die Messelektrode (7a, 7b) gegen eine Rückstellkraft bewegbar ist, so dass das Kabel in die Kabelaufnahme (11, 11a, 11b, 11c) einschiebbar ist, bis die Messelektrode (7a, 7b) unter Pressung am metallischen Kern (6) anliegt, und die Messelektrode (7a, 7b) dem Kabel beim Einschieben einen federnd beweglichen Widerstand bietet, wobei der Kabelaufnahme (11, 11a, 11b, 11c) Arretiermittel (15) zugeordnet sind, die gegen den Mantel des Kabels drücken und das Kabel dadurch kraftschlüssig in der Kabelaufnahme (11, 11a, 11b, 11c) fixieren.

2. Sicherheits-Kontaktiervorrichtung nach Anspruch 1, **dadurch gekennzeichnet, dass** die Arretiermittel (15) durch eine Betätigungseinrichtung händisch bedienbar sind, um das Kabel freizugeben oder zu fixieren.

3. Sicherheits-Kontaktiervorrichtung nach Anspruch 2, **dadurch gekennzeichnet, dass** die Betätigungseinrichtung einen Hebel (17) aufweist, der um eine Schwenkachse schwenkbar ist.

4. Sicherheits-Kontaktiervorrichtung nach einem der voranstehenden Ansprüche, **dadurch gekennzeichnet, dass** der Grundkörper (10, 10a) mindestens eine Leitung (8) mit einem Stecker aufweist, wobei die Leitung (8) elektrisch leitend mit der Messelektrode (7a, 7b) verbunden ist.

5. Sicherheits-Kontaktiervorrichtung nach einem der voranstehenden Ansprüche, **dadurch gekennzeichnet, dass** der Grundkörper (10, 10a) zwei Kabelaufnahmen (11a, 11b) mit jeweils einer der jeweiligen Kabelaufnahme (11a, 11b) zugeordneten Messelektrode (7a, 7b) aufweist.

6. Sicherheits-Kontaktiervorrichtung nach einem der voranstehenden Ansprüche, **dadurch gekennzeichnet, dass** eine Kabelaufnahme (11c) mehrere hintereinander angeordnete Arretierbereiche mit jeweils zu einem anderen Arretierbereich unterschiedlichem Innendurchmesser aufweist.

7. Sicherheits-Kontaktiervorrichtung nach einem der voranstehenden Ansprüche, **dadurch gekennzeichnet, dass** diese mittels einer Leitung (8) mit einem Messgerät zur Messung von elektrischen Strömen oder Spannungen verbunden ist oder dass der Grundkörper (10, 10a) einstückig mit einem solchen Messgerät ausgebildet ist.

## Claims

1. Safety contact device for recognition of two cables, which belong to one another, of a solar cell series circuit, comprising at least one first measuring electrode (7a, 7b) with a tip for application to the core (6) of a first cable, with a base body (10, 10a) with a cable mount (11, 11a, 11b, 11c) for introduction and retention of at least one of the cables, wherein the measuring electrode (7a, 7b) is guided within the base body (10, 10a) by guide means and can be brought in the direction of the cable mount (11, 11a, 11b, 11c) and/or of the cable, wherein the cable mount (11, 11a, 11b, 11c) is arranged coaxially with the movement axis through the measuring electrode (7a, 7b) so that the tip of the measuring electrode always meets the metallic core (6) of the first cable, wherein the guide means comprise a spring (12) by which the measuring electrode (7a, 7b) is resiliently mounted, wherein the measuring electrode (7a, 7b) is movable against a restoring force so that the cable can be pushed into the cable mount (11, 11a, 11b, 11c) until the measuring electrode (7a, 7b) bears under pressure against the metallic core (6), and the measuring electrode (7a, 7b) offers a resiliently movable resistance to the cable during pushing in, wherein associated with the cable mount (11, 11a, 11b, 11c) are locking means (15) which press against the casing of the cable and thereby fix the cable in the cable mount (11, 11a, 11b, 11c) by friction couple.

2. Safety contact device according to claim 1, **characterised in that** the locking means (15) are manually operable by an actuating device in order to free or fix the cable.

3. Safety contact device according to claim 2, **characterised in that** the actuating device comprises a lever (17) pivotable about a pivot axis.

4. Safety contact device according to any one of the preceding claims, **characterised in that** the base body (10a, 10b) comprises at least one line (8) with a plug, wherein the line (8) is electrically conductively connected with the measuring electrode (7a, 7b).

5. Safety contact device according to any one of the preceding claims, **characterised in that** the base body (10, 10a) comprises two cable mounts (11a, 11b) each with a respective measuring electrode (7a, 7b) associated with the respective cable mount (11a, 11b).

6. Safety contact device according to any one of the preceding claims, **characterised in that** a cable mount (11c) comprises a plurality of locking regions, which are arranged one behind the other, with in each instance an internal diameter different from another locking region.

7. Safety contact device according to any one of the preceding claims, **characterised in that** this is connected by means of a line (8) with a measuring instrument for measuring electric currents or voltages or the base body (10, 10a) is constructed integrally with such a measuring instrument.

## Revendications

1. Dispositif de contact de sécurité destiné à identifier deux câbles correspondant l'un à l'autre d'un branchement en série de cellules solaires, comprenant au moins une première électrode de mesure (7a, 7b) avec une pointe destinée à être placée sur l'âme (6) d'un premier câble, avec un corps de base (10, 10a) avec un logement de câble (11, 11a, 11b, 11c) pour introduire et maintenir au moins un des câbles, dans lequel l'électrode de mesure (7a, 7b) est guidée par des moyens de guidage à l'intérieur du corps de base (10, 10a) et peut être amenée en direction du logement de câble (11, 11a, 11b, 11c) et/ou du câble, le logement de câble (11, 11a, 11b, 11c) étant disposé de manière coaxiale par rapport à l'axe de déplacement à travers l'électrode de mesure (7a, 7b) de telle sorte que la pointe de l'électrode de mesure atteint toujours l'âme métallique (6) du premier câble, les moyens de guidage comprenant un ressort (12), l'électrode de mesure (7a, 7b) étant montée sur ressorts, l'électrode de mesure (7a, 7b) pouvant être déplacée à l'encontre d'une force de rappel de telle sorte que le câble peut être enfilé dans le logement de câble (11, 11a, 11b, 11c) jusqu'à ce que l'électrode de mesure (7a, 7b) repose par pression sur l'âme (6) métallique, et que l'électrode de mesure (7a, 7b) offre au câble lors de l'enfilage une résistance mobile de manière élastique, des moyens d'arrêt (15) étant associés au logement de câble (11, 11a, 11b, 11c), qui exercent une pression contre la gaine du câble et fixent ainsi le câble de manière solidaire dans le logement de câble (11, 11a, 11b, 11c).

2. Dispositif de contact de sécurité selon la revendication 1, **caractérisé en ce que** les moyens d'arrêt (15) sont opérables manuellement via un système d'actionnement, pour débloquer ou fixer le câble.

3. Dispositif de contact de sécurité selon la revendication 2, **caractérisé en ce que** le système d'actionnement présente un levier (17), qui peut être pivoté autour d'un axe de pivotement.

4. Dispositif de contact de sécurité selon l'une quelconque des revendications précédentes, **caractérisé en ce que** le corps de base (10, 10a) présente au moins un fil (8) avec une fiche, dans lequel le fil (8) est relié de manière électriquement conductrice à l'électrode de mesure (7a, 7b).

5. Dispositif de contact de sécurité selon l'une quelconque des revendications précédentes, **caractérisé en ce que** le corps de base (10, 10a) présente deux logements de câble (11a, 11b) avec respectivement une électrode de mesure (7a, 7b) associée au logement de câble (11a, 11b) respectif.

6. Dispositif de contact de sécurité selon l'une quelconque des revendications précédentes, **caractérisé en ce qu'**un logement de câble (11c) présente plusieurs zones d'arrêt disposées les unes derrière les autres avec chacune un diamètre intérieur différent par rapport à une autre zone d'arrêt.

7. Dispositif de contact de sécurité selon l'une quelconque des revendications précédentes, **caractérisé en ce que** celui-ci est relié au moyen d'un fil (8) à un appareil de mesure destiné à mesurer des courants ou des tensions électriques, ou que le corps de base (10, 10a) est réalisé d'un seul tenant avec un appareil de mesure de ce type.
